Europäisches Patentamt

European Patent Office

Office européen des brevets

(19)

(11) Veröffentlichungsnummer: **0 019 261**
**B1**

(12) **EUROPÄISCHE PATENTSCHRIFT**

(45) Veröffentlichungstag der Patentschrift: **01.06.83**

(21) Anmeldenummer: **80102635.2**

(22) Anmeldetag: **12.05.80**

(51) Int. Cl.³: **H 04 B 1/64**

(54) Einstellbares Dämpfungsglied für eine digitale Fernmelde-, insbesondere Fernsprechvermittlungsanlage.

(30) Priorität: **21.05.79 US 40705**

(43) Veröffentlichungstag der Anmeldung:
**26.11.80 Patentblatt 80/24**

(45) Bekanntmachung des Hinweises auf die Patenterteilung:
**01.06.83 Patentblatt 83/22**

(84) Benannte Vertragsstaaten:
**AT CH DE FR GB IT LI SE**

(56) Entgegenhaltungen:
**FR - A - 2 312 883**
**FR - A - 2 335 101**
**GB - A - 1 325 193**
**US - A - 3 575 591**

(73) Patentinhaber: **SIEMENS AKTIENGESELLSCHAFT**
**Berlin und München Wittelsbacherplatz 2**
**D-8000 München 2 (DE)**

(72) Erfinder: **Southard, Gary, D.**
**8264 NW 1st Street**
**Coral Springs Florida 33065 (US)**

Courier Press, Leamington Spa, England.

### Einstellbares Dämpfungsglied für eine digitale Fernmelde-, insbesondere Fernsprechvermittlungsanlage

Die Erfindung bezieht sich auf ein einstellbares Dämpfungsglied zum Verändern der Amplitude von pulscodemodulierten Werten (PCM-Wörtern) einer Schwingung in einer digitalen Fernmelde-, insbesondere Fernsprechvermittlungsanlage, bei dem ein erstes Bit jedes Wertes einer Schwingung das Vorzeichen des durch die nachfolgenden Bits festgelegten Wertes angibt.

Derartige einstellbare Dämpfungsglieder oder Verstärker sind beispielsweise aus der GB—A—1 325 193 bekannt. Bei den Anordnungen nach dieser Literaturstelle wird in einer Amplituden-Vervielfachungseinheit eine derartige Verstärkung oder Dämpfung der Tonfrequenz vorgenommen, daß die Soll-Lautstärke des jeweiligen auf den anschliessenden Kompressor und Parallel-Serien-Wandler gegebenen Tones erreicht ist. Eine Verstärkungssteuerung gibt dabei ein Verstärkungsfaktor der Vervielfachungseinheit vor. Da die Amplituden der Tonfrequenzen pulscodemoduliert vorliegen und in gleicher Form auch wieder ausgegeben werden, enthält die Vervielfachungseinheit eine sehr umfangreiche Umrechnungstabelle, falls mehr als nur wenige Verstärkungsfaktoren berücksichtigt werden müssen. Die Kompressionskennlinie wird dem Verändern der Dämpfungswerte nicht zugrundegelegt, was zur umfangreichem Umrechnungstabelle führt.

Eine solche Umrechnungstabelle wird auch bei der DE—A—26 56 133 (FR—A—2 335 101) verwendet. Dort werden von der Steuerung auch die Anzahl der Dämpfungsschritte (—3 dB) angegeben. Für n-Schritte muß auch n-mal umgesetzt werden. Außerdem sind keine kleineren Schritte als —3 dB möglich. Ferner wird auch nicht die Kompressionskennlinie zugrunde gelegt. Es handelt sich vielmehr um ein Verfahren zur numerischen Regelung von Dämpfung/Verstärkung mittels Wertzuwachs der Signalpegel, wobei die analogen Signalpegel nach einem bestimmten Gesetz in codierten Binärwerten wiedergegeben sind. Nur die positiven bzw. negativen Signalpegelveränderungen werden mit einem Bit des codierten Wertes angegeben.

In der vorgenannten DE—A—26 56 133 (FR—A—2 335 101) handelt es sich also nicht um die Veränderung von Dämpfungs- und Verstärkungswerten in sehr kleinen, beispielsweise einem dB-Schritt, entsprechenden Schritten durch bestimmte Verlagerung der Amplitudenwerte. Es besteht auch nicht die Möglichkeit, zunächst in großen Stufen und innerhalb der bestimmten großen Stufen in kleinen Schritten die Dämpfungs- bzw. Verstärkungswerte zu ändern, so daß der erforderliche Programmaufwand bei der bekannten Technik wesentlich umfangreicher sein muß.

Ebenso der Aufwand an Umsetz- und Ansteuerinformationen.

In der US—A—3.575.591 ist speziell eine Kompressions-Kennlinie mit dreizehn Segmenten, A-Kennlinie genannt, beschrieben. Als Codewort wird dabei ein bezüglich einer Null-linie symetrischer Binärcode verwendet, bei dem das erste Bit eine Aussage über die Polarität des Abtastwertes macht (Vorzeichen Bit), während die übrigen Bits binär abgestuft sind. Jedes Codewort entspricht einem Abtastwert eines Amplitudenwertes und ist in einem Binärcode bestehend aus sieben Ziffern festgelegt. (Vergleiche Spalte 4, Zeile 3 bis 62, der US—A—3.575.591). Im weiteren betrifft diese US—PS eine Konferenzschaltung und nicht die Dämpfung von Amplitudenwerten.

Die vorstehend genannten bekannten Anordnungen behandeln zwar die Veränderung von vorgegebenen PCM-Werten bzw. PCM-Wörtern, die bestimmte Signalwerte angeben in Abhängigkei von bestimmten Dämpfungswerten, jedoch sind in der Regel Umsetzungen erforderlich, die je möglichem Signalwert, d.h. PCM-Wert auch Speicherplätze für alle notwendigen Dämpfungswerte aufweisen. Außerdem ist es mit den bekannten Verfahren und Anordnungen nicht möglich, beliebige Dämpfungswerte ohne zusätzlichem Aufwand einzustellen.

Die Aufgabe der vorliegenden Erfindung besteht darin, ein einstellbares, digitales Dämpfungsglied zu bilden, mit dessen Hilfe Dämpfungs- und Verstärkungswerte in großen und in kleinen Stufen, beispielsweise von etwa einem dB, gestaffelt regelbar sind, so daß diese Dämpfungsglied nicht nur universell eingesetzt werden kann, sondern auch jede Anforderung bezüglich des Dämpfungsfaktors bis zu geradzahligen Werten genau gerecht wird.

Dies wird dadurch erreicht, daß ein erster, die höherwertigen, weiteren Bits jedes Wertes einer Schwingung, die die Zugehörigkeit des Wertes zu einem bestimmten Qantisierungssegment von einer festgelegten Anzahl von Quantisierungssegmenten angeben, aufnehmenden Speicher vorgesehen ist, der den Amplitudenwert diese Wertes aufgrund eines die Zahl der notwendigen einer bestimmten Dämpfung entsprechenden Dämpfungsschritte kennzeichnenden Signals der Steuerung durch eine entsprechende Anzahl von Verschiebungen derart verändert, daß dieser Amplitudenwert in ein anderes der erforderlichen Dämpfung entsprechendes Quantisierungssegment verlagert wird und daß ferner ein die restlichen Bits, welche die Lage des Amplitudenwertes innerhalb eines Quantisierungssegmentes bezeichnen, in kleinen Stufen aufgrund entsprechender Signale der Steuerung verändernder, zweiter Speicher vorgesehen ist.

Dadurch, daß das Dämpfungsglied in zwei Teile unterteilt ist, von denen der erste Teil, als Speicher mit Umsetzmöglichkeit, eine Festlegung der Dämpfung nach großen Stufen vornimmt und erst im zweiten Teil, im Speicher mit weiterer Umsetzmöglichkeit, innerhalb der festgelegten großen Stufe noch eine Feinteilung der Dämpfung vorgenommen werden kann, ist der Aufwand für die Veränderung der Amplitudenwerte erheblich verringert. Es kann nämlich in bestimmten Fällen, wenn dem Dämpfungsglied linearcodierte PCM-Wörter zugeführt werden, dieser erste Speicher besonders einfach gestaltet werden. Bei Verwendung eines Schieberegisters braucht dann der Bitwert nur um eine Stelle weiter nach rechts geschoben zu werden und man erhält dadurch den Bitwert des PCM-Wortes um genau sechs dB gedämpft. Ein derartiger Speicher ist leicht zu realisieren und arbeitet sehr schnell. Da die Dämpfung durch Veränderung der Amplitudenwerte in zwei Stufen vorgenommen wird, können die Umsatztabellen wesentlich kleiner sein als wenn jeder Eingangswert entsprechend den insge- samt möglichen Dämpfungsfaktoren jeweils in dem Ausgangs- wert umgesetzt werden muß. Bei der erfindungsgemäßen Anordnung sind viel weniger Speicherplätze erforderlich.

Gemäß einer weiteren Ausbildung der Erfindung sind die beiden, zur Umsetzung von Bitwerten vorgesehenen Speicher von einer gemeinsamen Steuerung ansteuerbar.

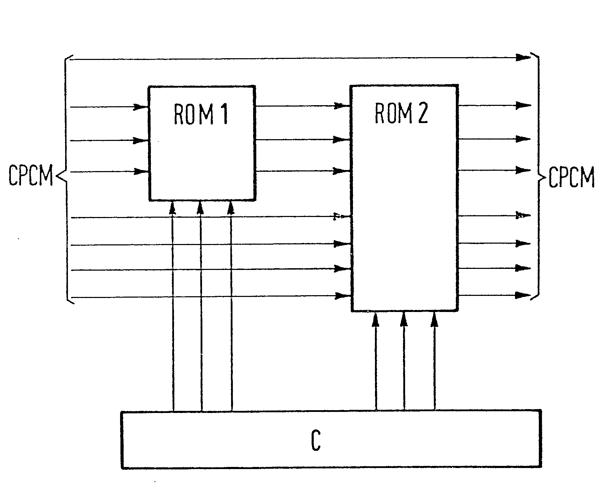

Ein Beispiel der Erfindung wird anhand der Zeichnung näher beschrieben. Bei diesem Beispiel wird vorausgesetzt, daß dem Dämpfungsglied kompandierte PCM-Wörter (CPCM) zugeführt und ebensolche entnommen werden. Außerdem wird noch ein Beispiel beschrieben, bei dem am Eingang des Dämpfungsgliedes lineare PCM-Wörter anliegen und diese gleich im Dämpfungsglied kompandiert werden.

Eine Kompandierungskennlinie für PCM-Wörter, nach Werten einer Schwingung, ist durch die DE—B—1 802 222 (entspricht US—A—3.575.591) bekannt. Als Code wird dabei ein bezüglich einer Null-Linie symmetrischer Binärcode verwendet, bei dem das erste Bit eine Aussage über die Polarität des Abtastwertes und somit über das Vorzeichen macht. Die übrigen Bits sind binär abgestuft. Das Vorzeichenbit wird in einem Dämpfungsglied nicht verändert und ist deshalb auch in der Zeichnung an den beiden Speichern ROM1 und ROM2 des Dämpfungsgliedes vorbeigeführt. Dieses Vorzeichenbit bleibt auch dann bestehen, wenn das PCM-Wort aus einem linearen Code (LPCM) in einen kompandierten Code (CPCM) umgewandelt wird.

Für dieses Beispiel sei angenommen, daß jedes PCM-Wort aus 8 Bits besteht. Das erste Bit ist, wie schon vorhin gesagt, das Vorzeichenbit und ist in der Zeichnung als oberster waagerechter Strich dargestellt. Die darunterliegenden drei Striche, entsprechend dem zweiten bis vierten Bit, werden einem ersten Speicher ROM1 zugeführt, um anschließend zu einem zweiten Speicher ROM2 weitergeleitet zu werden. In diesem zweiten Speicher ROM2 werden die mit Hilfe des ersten Speichers ROM1 und einer Steuerung C umgesetzten Bits zwischengespeichert, um anschließend, zusammen mit den im zweiten Speicher ROM2 mit Hilfe der Steuerung C umgesetzten fünften bis achten Bits ausgegeben zu werden.

Die Funktion der prinzipiellen Zusammenarbeit zwischen Steuerung und Speicher kann insbesondere der GB—A—1 325 193 entnommen werden.

Die gesamte Umsetzung, die Weitergabe vom ersten zum zweiten Speicher, die Aufnahme in die einzelnen Speicher und die Ausgabe werden von einer Steuerung C gesteuert und überwacht.

Der erste Speicher ROM1 und der Teil des zweiten Speichers ROM2, in dem die kompandierten Bits der PCM-Wörter aufgenommen werden, sind jedem eingegebenen Wert, bestehend aus einer bestimmten Bitkonfiguration, eine Anzahl von Bitkonfigurationen zugeordnet, welche dem Ausgang zugeführt werden. Welche Ausgangswerte im jeweiligen Fall entnommen werden, wird jeweils von der Steuerung C des Dämpfungsgliedes bestimmt. Diese Steuerung C bekommt seine Informationen von einer anderen, hier nicht dargestellten Stelle, die die jeweils benötigten Amplituden oder Verstärkungs- oder Dämpfungsfaktoren kennt.

Diese Dämpfungsfaktoren werden in der Regel ebenfalls binär über die jeweils senkrecht gezeichneten drei Adern den Speichern ROM1 und ROM2 zugeführt.

Das zweite, dritte und vierte Bit jedes PCM-Wortes geben zusammen das Segment auf der Quantisierungslinie an, das dem Amplitudenwert entspricht. Die restlichen Bits bezeichnen die Quantisierungsintervalle jeweils innerhalb eines Segments.

Mit Hilfe des ersten Speichers ROM1 kann also der Amplitudenwert von Segment zu Segment der Kompanderkennlinie verschoben werden. Nachdem die Kompanderkennlinie eine logarithmische Kurve ist, ändert sich der Amplitudenwert beim Verschieben zum nächst tieferen Segment um den Faktor 2. In vielen Fällen wird eine derartige Veränderung des Amplitudenwertes schon ausreichen. Sollte das jedoch noch nicht, genügen, so kann durch die Umsetzung mittels des zweiten Speichers ROM2 noch eine Feinkorrektur vorgenommen werden. Wenn also beispielsweise im ersten Bauteil eine Dämpfungsstufung von sechs dB vorgesehen ist, so können mit dem zweiten Speicher ROM2 Dämpfungsstufen von beispielsweise einem dB erreicht werden, was die Forderungen aller Betreiber von Fernmeldeanlagen erfüllt.

In diesem Beispiel sind vier Bit zum Festlegen der Quantisierungsintervalle vorgesehen.

Je nach der geforderten Genauigkeit der Quantisierung können aber auch mehr oder weniger Bits verwendet werden.

Aus dem zweiten Speicher ROM2 gelangt dann das umgesetzte, gedämpfte, kompandierte PCM-Wort zu den Einrichtungen der Vermittlung, um von dieser dann weiter verarbeitet zu werden.

Werden dem Dämpfungsglied aber keine kompandierten PCM-Wörter (CPCM) zum Dämpfen zugeliefet, sondern lineare PCM-Wörter (LPCM), so kann anstelle der Umsetzung mit dem zweiten Speicher ROM2 als erster Speicher ROM1 ein Schieberegister verwendet werden, in das die drei Bits zum Festlegen der Quantisierungsintervalle eingetragen sind. Zur Halbierung des Amplitudenwertes genügt es dann, die Bits des Schieberegisters um eine Stelle nach rechts zu verschieben. Werden die Bits um noch eine zweite Stelle verschoben, so wird der Amplitudenwert nochmals halbiert, so daß jetzt nur noch ein Viertel davon vorhanden ist. Allgemein gesagt, bei einem Verschieben um n Stellen ergibt sich ein Wert, der mit n×6 dB bedämpft ist.

Bei einer derartigen Bitverschiebung ergeben sich jedoch Überträge, die nicht vernachlässigt werden dürfen, sondern im zweiten Speicher ROM2 mitberücksichtigt werden müssen. Zu diesem Zweck werden die im ersten Speicher ROM1 wegfallenden Bits in die Steuerung C gegeben, welche entsprechend die Steuerbits für den zweiten Speicher ROM2 verändert.

Da der Ausgang des Dämpfungsgliedes die PCM-Wörter in kompandierter Form zum Abruf bereithalten muß, ist der zweite Speicher ROM2 mit einem Kompanderteil ergänzt, das die PCM-Wörter, soweit nicht schon mit Hilfe der Umsetztabelle im zweiten Speicher ROM2 geschehen, in kompandierte PCM-Wörter (CPCM) umwandelt.

Das beschriebene Dämpfungsglied ermöglicht es, Dämpfungswerte von Null an in ein dB-Schritten vorzusehen. In üblichen digitalen Fernmeldevermittlungen werden jedoch nicht alle diese Dämpfungswerte benötigt, so daß bei der Bemessung des Dämpfungsgliedes ein Teil der Speicherplätze eingespart werden kann. Wenn anstelle von Dauerspeicher ROM programmierbare Speicher ROM verwendet werden, können nachträglich anstelle von vorhandenen Werten durch Ändern der Werte für die Quantisierungsintervalle beliebige andere Dämpfungswerte erreicht werden.

## Patentansprüche

1. Einstellbares Dämpfungsglied zum Verändern der Amplitude von pulscodemodulierten Werten (PCM-Wörtern) einer Schwingung in einer digitalen Fernmelde-, insbesondere Fernsprechvermittlungsanlage, bei dem ein erstes Bit jedes Wertes einer Schwingung das Vorzeichen des durch die nachfolgenden Bits festgelegten Wertes angibt, dadurch gekennzeichnet, daß ein erster, die höherwertigen, weiteren Bits jedes Wertes (PCM-Wortes) einer Schwingung, die die Zugehörigkeit des Wertes (PCM-Wortes) zu einem bestimmten Quantisierungssegment von einer festgelegten Anzahl von Quantisierungssegmenten angeben, aufnehmender Speicher (ROM1) vorgesehen ist, der den Amplitudenwert dieses Wertes (PCM-Wortes) aufgrund eines die Zahl der notwendigen einer bestimmten Dämpfung entsprechenden Dämpfungsschritte (6 dB) kennzeichnenden Signals der Steuerung (C) durch eine entsprechende Anzahl von Verschiebungen derart verändert, daß dieser Amplitudenwert in ein anderes der erforderlichen Dämpfung entsprechendes Quantisierungssegment verlagert wird und daß ferner ein die restlichen Bits, welche die Lage des Amplitudenwertes innerhalb eines Quantisierungssegmentes bezeichnen, in kleinen Stufen (1 dB) aufgrund entsprechender Signale der Steuerung (C) verändernder, zweiter Speicher (ROM2) vorgesehen ist.

2. Einstellbares Dämpfungsglied nach Anspruch 1, dadurch gekennzeichnet, daß der erste Speicher (ROM1) ein die Veränderung des Wertes einer Schwingung durch eine bestimmte Anzahl von Verschiebungen in einem von der Steuerung (C) bestimmten Quantisierungssegment bewirkendes Schieberegister ist.

3. Einstellbares Dämfpungsglied nach Anspruch 1, dadurch gekennzeichnet, daß der zweite Speicher unter Zuhilfenahme der Steuerung (C) für eingegebene Bitwerte die den kleinen Dämpfungsstufen entsprechenden, kompandierten Werte liefert.

## Revendications

1. Atténuateur réglable pour modifier l'amplitude de valeurs modulées par impulsions et codage (mot PCM) d'une oscillation dans un central numérique de télécommunications, notamment téléphonique, dans lequel un premier bit de chaque valeur d'une oscillation indique le signe de la valeur qui est déterminée pour les bits suivants, caractérisé par le fait qu'il est prévu, pour recevoir les autres bits de poids plus élevés de chaque valeur (mot-PCM) d'une oscillation, qui indiquent l'appartenance de la valeur (du mot PCM) à un segment de quantification déterminé à un nombre déterminé de segments de quantification, une première mémoire (ROM1) qui modifie la valeur de l'amplitude de ce mot (mot PCM) de telle manière, sur la base d'un signal de commande (C) qui caractérisé le nombre nécessaire de pas d'atténuation (6 dB) qui correspondent à une atténuation déterminée, que cette valeur d'amplitude est déplacée dans un autre segment de quantification qui correspond à l'atténuation nécessaire, et qu'il est en outre prévu une seconde mémoire (ROM2) qui modifie les bits restants qui désignent la position de la valeur de l'amplitude à l'intérieur d'un segment de quantification, par petits paliers (1 dB), sur la basse de signaux correspondant de la commande (C).

2. Atténuation réglable selon la revendication 1, caractérisé par le fait que la première mémoire (ROM1) est un registre à décalage qui provoque la modification de la valeur d'une oscillation par un nombre déterminé de décalages dans un segment de quantification déterminé par la commande (C).

3. Atténuateur réglable selon la revendication 1, caractérisé par le fait que la seconde mémoire fournit, avec l'aide de la commande (C), pour les valeurs binaires introduites, des valeurs qui ont subi une compression et une expansion et qui correspondent aux faibles paliers d'atténuation.

## Claims

1. Adjustable attenuation element for modifying the amplitude of pulse-code-modulated values (PCM-words) of an oscillation in a digital telecommunications exchange system, in particular telephone exchange system, wherein a first bit of each value of an oscillation indicates the sign of the value specified by the subsequent bits, characterised in that there is provided a first store (ROM1) which accommodates the higher-level, further bits of each value (PCM-word) of an oscillation which indicate the association of the value (PCM-word) with a particular quantization segment of a given number of quantization segments and which store modifies the amplitude value of this value (PCM-word), on the basis of a signal of the control unit (C) characterising the number of the required attenuation steps (6 dB) corresponding to a particular attenuation, by means of an appropriate number of shifts in such manner that this amplitude value is displaced into another quantization segment corresponding to the required attenuation, and that furthermore a second store (ROM2) is provided, which modifies the remaining bits, which define the position of the amplitude value within a quantization segment, in small steps (1 dB) on the basis of appropriate signals of the control unit (C).

2. Adjustable attenuation element as claimed in claim 1, characterised in that the first store (ROM1) is a shift register which effects the modification of the value of an oscillation by a particular number of shifts in a quantization segment which is determined by the control unit (C).

3. Adjustable attenuation element as claimed in claim 1, characterised in that with the aid of the control unit (C), the second store supplies the companded values, which correspond to the small attenuation steps, for input bit values.